# EUROPEAN PATENT SPECIFICATION

(11) **EP 3 812 352 B1**
(45) Date of publication and mention of the grant of the patent: **04.06.2025**
(21) Application number: 19205115.9
(22) Date of filing: 24.10.2019
(51) Int. Cl.: B23K 26/0622, C03B 23/24, B23K 26/20, B23K 26/244, B23K 26/324, B23K 26/22, B23K 101/18, B23K 101/36, B23K 103/00, B81C 1/00

(54) **GLASS COMPOUND ARRANGEMENT**
GLASVERBUNDANORDNUNG
AGENCEMENT DE COMPOSÉ DE VERRE

(43) Date of publication of application: 28.04.2021
(73) Proprietor: Schott Primoceler Oy, 33720 Tampere (FI)
(72) Inventor: THOMAS, Jens Ulrich, 55128 Mainz (DE); MÄÄTTÄNEN, Antti, 33710 Tampere (FI)
(74) Representative: Blumbach · Zinngrebe Patentanwälte PartG mbB

(56) References cited:
- EP-A1- 2 075 082
- WO-A1-2018/211176
- JP-A- 2000 313 630
- US-A1- 2015 273 624

## Description

### Field of the invention

The invention is related to a glass compound arrangement, for example for providing a hermetically sealed compartment in at least two layers of said glass compound arrangement, as well as a manufacturing process for making the same.

### Background and Summary of the invention

International document WO 2018/211176 A1 describes an article comprising a hermetically closed cavity, wherein the article is produced by welding a first piece to a second piece with a laser beam.

Japan laid open document JP 2000-313630 A shows fusing two glass plates by means of laser light, where a first irradiation light is used for preheating a fusion zone, a second irradiation light is used for performing a fusion process in the fusion zone, and a third irradiation light is used for slow cooling the fusion zone to reduce temperature gradient in the glass during slow cooling. It is not shown to form or provide enclosures.

US Patent Application Publication US 2015/0273624 A1 concerns a laser joining method to join two objects which are in contact with each other. However, enclosures are not described.

European Patent Application EP 2 075 082 A1 concerns a method for joining two substances. No enclosures are described.

But glass and glass-like enclosures can be used, for example, to protect electronics, circuitry or sensors. It is possible to use hermetically sealed implementations of aforementioned enclosures for medical implants for example in a therapy to cure a heart disease, or for example in a retina or for any type of bio-processor. Known are bio-processors which are made from titan.

Sensors can be protected by means of the invention e.g. for the use in particular rough climate conditions. Further examples are Micro-Electro-Mechanic-Systems (MEMS), a pressure sensor, blood gas sensor, a glucose meter such as a blood glucose meter or the like.

Further fields of usage for the present invention can be found in protection sleeves for cell phones, in the field of virtual reality and augmented reality goggles and headsets and similar devices. For example, the invention may also be used in the scope of electromobility; But also in aviation and space environment, in high temperature environments and in the field of micro optics the invention might be used.

The before-mentioned applications all concern some form of electronic device, which is faced with rough environmental conditions and which thus has to be especially robust - or protected from these conditions. So for example in order to allow for the use of any electronics, which may be expected not to survive the before-mentioned environmental conditions, but which may be made cheaper or where even no rough electronics exist which could withstand in this conditions, the invention may be used to protect such devices like electronics.

Further, the invention allows to some extent an exchange or way of communication with the inner region of the device according to the invention, e.g. the enclosure, or the cavity situated inside the enclosure. This exchange or way of communication can be realized e.g. by means of electromagnetic radiation e.g. in visible light region and/or in the region of microwave radiation. For realization of the same, the enclosure is, at least in part and/or at least for a range of wave lengths, transparent. This transparency allows for communication methods, for any kind of data or energy transmission, and for measurements with and by electronics or sensors situated inside a cavity. In particular, optical communication methods or optical data or energy transmission is possible.

However, implementing a cavity in the enclosure is only an embodiment for possible usages of the invention. As well be understood below, the invention is not limited to cavities, but it can be used for improving also enclosures having cavities.

It is principally known to put several parts or layers and to arrange them such that in an inner region components can be situated. For example European Patent EP 3 012 059 B1 shows a method for manufacturing a transparent component for protecting an optical component. A new laser welding method is used therein.

The present invention may be seen in the vicinity of improving reliability and/or robustness of enclosures, e.g. regarding environmental conditions.

It is an object of the invention to increase the mechanical stability of the enclosure.

The object of the invention is achieved by subject matter of the independent claims. Preferred embodiments of the invention are subject of the dependent claims.

According to the invention, a hermetically sealed enclosure comprises at least a base substrate and a cover substrate, which constitute at least a part of the enclosure. A function zone is situated such that it is circumferentially enclosed in the enclosure, e.g. surrounded by said base substrate and said cover substrate. Said substrates can be of a variety of materials e.g. ranging from homogenous of glass or monocrystalline silicon to more complex substrates like a chemical hardened glass that is covered with a multilayer optical coating.

At least the cover substrate of the enclosure comprises a glass or glass-like material, e.g. glass ceramics or crystallines. Furthermore, silicone based substrates as base and/or cover substrate can be used, also in combination with the glass or glass based substrates. The base substrate and the cover substrate are hermetically welded by means of at least one laser weld line. The laser weld line is typically obtained by shooting a short pulsed laser beam from a laser source into the material with a defined wave length and energy so that a series of beam spots is placed into the material of the enclosure at each laser focus which is set in the laser source. By placing the beam spots so close together that the resulting nonlinear absorption zone at least is in contact with the neighbouring nonlinear absorption zone, or even overlaps with it, heat accumulation can occur that produces a continuous welding "line" can be obtained. In some aspects this can be seen as being in quite a similar manner as known welding methods e.g. for welding metal, where it is also possible even by means of a point-by-point spot-welding method to obtain a near-to-continuous weld line in the metal in the end. More specifically, the invention relates to an enclosure as defined in claim 1, to the use of said enclosure as defined in claim 18, to a method of providing an enclosure as defined in claim 19 and to a tempered sealed enclosure as defined in claim 22.

The laser weld line comprises an height HL in a direction perpendicular to its connecting plane. The connecting plane is the direction, in which the neighbouring or consecutive beam spots are set. Typically, the laser welding is performed from an "above" perspective, in such a meaning, that the substrate stack is positioned e.g. on a surface - such as a table - and that the laser is shot from above at least through the uppermost substrate layer - or through more than one substrate layers - to the place of the beam focus. The height HL thus is measured in the direction of the laser beam, where the width of the laser weld line is measured perpendicular with respect to the direction of the laser beam.

When defining a first laser weld line in a certain amount of material in the enclosure, it may occur that a thermal stress is induced locally in that certain amount of material, for example in a region around the laser weld line. It thus may be the case, that the certain amount of material comprises a lower mechanical stability when one laser weld line has been defined. As this it has been found out, that also the enclosure as a whole may comprise a lower mechanical stability when only one laser weld line is provided for each contact surface.

Surprisingly, it has been found that when a second laser weld line is placed close to the first laser weld line, the same amount of material in the enclosure may achieve an improved mechanical stability, even improved with respect to the situation without any laser weld line. So to say, by defining the second laser weld line in the enclosure, which at least overlaps with the first laser weld line, it is possible to reduce thermal stress at least in said amount of material. Additionally, it is possible to reduce also thermal stress in the enclosure as a whole when positioning the second laser weld line overlapping with the first laser weld line.

The enclosure as described in the application documents comprises an improved mechanical stability. This said, the mechanical stability is preferably improved by means of introducing at least two laser weld lines for each contact surface, wherein in between each two neighbouring substrate layers there is situated one contact surface. Additionally, the mechanical stability can be further improved when at each side of each contact surface there is at least one laser weld line overlapping with the laser weld line positioned at the other side of the same contact surface.

Additionally, or in other words, the mechanical stress in the at least one laser weld line is reduced, thus improving the mechanical stability of the hermetically sealed enclosure as a whole. This means, that by means of introducing an additional laser weld line into the material, and which overlaps with an "older" laser weld line which has already been placed in the material before, mechanical stress can be reduced or even eliminated in the material.

So to say, the mechanical stress in the at least one laser weld line, being the "older" laser weld line which is already placed in the material, is reduced by means of a stress reduction process step, and/or by means of a crack reduction step. During the stress reduction process step (which may also involve said crack reduction) any stress in the stress zone nearby the new laser spot can be changed. Depending on, among other adjustable features, where the new laser spot is set in the material, this may involve an increase of stress or a decrease up to ceasing of stress in the material.

The new laser spots can advantageously be set as another weld line, but it is not necessarily limited to this. So in other words, by means of thoughtful placement of laser spots, without the need of lining up the second laser spots in a sequence of a weld line, the stress can also be reduced. But the enclosure may comprise at least a second laser weld line situated next to the first laser weld line and/or situated such that a stress reduction is achieved by means of the second laser weld line. This is a preferred embodiment, as in the case when the second laser spots are set in the same sequence as the first ones, meaning that a second laser weld line is placed next to the first laser weld line, it can be assured in an easy manner that the stress introduced by the first laser weld line is eliminated throughout the material.

The first laser weld line may introduce a stress zone in the enclosure, where in the stress zone in inner stress or tension persists in the solidified material.

The second laser weld line is therefore advantageously positioned in or next to the stress zone induced by the first laser weld line. By this, the second laser weld line interacts with said stress zone, and can even eliminate the stress zone positioned next to the second laser weld line. In other words, the second laser weld line relieves the stress zone so that a stress-free or nearly stress-free zone is established, and/or so that the laser welded enclosure is stress-free or nearly stress-free.

The enclosure may comprise a cavity inside the enclosure, which may be, that said function zone is said cavity enclosed inside the enclosure. Residuent stress in the area of the cavities of a package can be especially critical because damage of the package is most often observed in the region where cavity reaches the frame of the package. It is advantageous to place an at least two dimensional laser weld line around the cavity for tempering the edges of the cavity, which is, for tempering the material situated around the cavity. By this, the inner side of the enclosure, which is surrounding the cavity or the cavities in the enclosure, can be tempered and strengthened, so that it may be more resistive with respect to any forces from inside or outside. For example, the inside of the cavity may comprise a higher or lower pressure as compared to the outside of the enclosure, thus introducing additional tension forces by the pressure difference. When the material surrounding the cavity/cavities in the enclosure is tempered, the enclosure can withstand higher forces without breaking or functional losses.

The at least one laser bond line can be designed to circumfere the function zone in a distance DF. This distance can be set as equal around the function zone. As an example, the distance may correspond to the height HF or less, or corresponds to double the height HF or less.

Each laser bond line may be situated such that it extends into two different substrates of the enclosure, wherein for example the laser bond line extends from the base cover layer into its neighbouring layer, e.g. the top cover layer, and wherein the laser bond line welds the two different substrates with each other.

The enclosure may comprise an elastic or flexible layer, in particular as an intermediate layer between other layers, so that the hermetically sealed enclosure is deformable e.g. by means of pressure change or by means of a mechanical force. By such an elastic layer, the enclosure could be used e.g. as an adjustable lens.

The enclosure can further be embodied to comprise an inner coating zone, positioned for example around the function zone. For example, the welding process using the laser source can be directed to change a material property on the surface areas directly surrounding the function zone / the cavity. This corresponds to putting a coating on said surface areas.

Further, each substrate may comprise multiple layers and be provided as a multilayer compound. So in other words, multilayer compounds can be used and adjoined by means of the laser welding process. This may include, that a multilayer compound is prepared in advance and is welded as a whole in the manufacturing process with one or more other substrates to provide for said enclosure.

By means of comprising multilayer compounds, further material properties can be added to the enclosure in an easy way. For example, such a multilayer compound can comprise a pre-stress, or a preferred pre-stress direction, so that when laser bonding such a multilayer compound the inner stress level of the multilayer compound can enhance for example the resistance of the enclosure, e.g. be a hardened multilayer compound. Thus an even improved hardening may result for the enclosure as a whole. Additionally or alternatively, such a multilayer compound can comprise a coating layer, for example a coating layer which is difficult to weld by means of laser welding, so that some of or all of the intermediate compound layers are provided as a "pack" or "stack" already sticked together. Such a coating may comprise an optical coating.

Glass or glass-like substrates, where an optical coating has been added on the front or back side or both, can also be welded to other substrates (coated or not) and subsequently hardened. Preferably, the substrate which comprises coating is at least partly transparent at the emitting wavelength of the welding laser, if it extends into the planned beamline of the welding laser. For example a substrate with an antireflection coating in the VIS wavelength regime is typically achieved by sputtering several alternating thin layers of Titanium Oxide and Silicon Oxide. Here welding can be achieved with a laser emitting in the NIR.

The enclosure may comprise any number of additional intermediate layers positioned in between the base layer and the cover layer, for example three intermediate layers.

The function zone may be situated in the or one of the intermediate layer(s). In this configuration, the function zone can be covered by said base layer on its bottom side and/or by said cover layer on its top side.

The function zone can be designed as a cavity, wherein a function component such as an electrical component can be arranged in said cavity to be protected by the enclosure.

The hermetically sealed enclosure can comprise one or more function component(s) comprising a power semiconductor, such as a GaN-LED, a SiC-, GaAs- or GaN- power transistor being positioned inside the cavity. Additionally or alternatively, the hermetically sealed enclosure can comprise through vias for establishing an electrical contact from the inside of the enclosure with the outside, e.g. for contacting a contact pad at the outside of the enclosure.

So at least one of the substrate layers, for example the base cover layer, may comprise one or more through vias for electrically contacting the function zone with the surrounding outside of the enclosure, for example a contact pad on the lower side of the base cover layer.

The substrates of the enclosure may comprise a thickness of below 3 mm, preferably below 1500 µm, preferably below 500 µm, preferably below 120 µm and further preferably below 80 µm. The base cover layer and/or the top cover layer may also be thinner than the one or more intermediate layers, for example comprising half the width of the intermediate layers or less. The enclosure may comprise a size of 10 mm x 10 mm or less, preferably 5 mm x 5 mm or less, further preferably 2 mm x 2 mm or 1 mm x 1 mm or less. Also, the enclosure may comprise an height which is greater than its width.

According to the invention is also the use of a hermetically sealed enclosure for making a medical implant, a micro lens compound, a micro optical chip, a pharma packaging, or an LED device, as defined in claim 18.

Further according to the invention is also a method of providing a hermetically sealed enclosure, as defined in claim 19 and for example as explained in detail above and below, in particular wherein the enclosure encloses a function zone such as a cavity, the method comprising the steps of providing a base substrate and aligning a cover substrate above the base substrate in such a way, that at least one contact surface is arranged between the base substrate and the cover substrate. Hermetically sealing the function zone by means of introducing a first laser weld line in the enclosure, introducing a second laser weld line at the same position as the first laser weld-line or at a position close to or overlapping with the first laser weld line; and relieving stress in the area of the first laser weld line of the enclosure by means of introducing said second laser weld line.

In the method a laser beam source can be used to introduce the laser weld lines into the enclosure. The laser beam can be guided around the function zone for making the laser weld line along the contact area between the base substrate (3) and its neighbouring substrate, e.g. the cover substrate.

Said laser source can be a pulsed laser source, wherein several laser pulses are introduced along the laser weld line, so that a continuous or continuous-like weld-line is composed from the several laser pulses.

According to the invention there is also provided a tempered sealed enclosure made by the method as depicted above and below and defined in claim 22.

The invention is described in more detail and in view of preferred embodiments hereinafter. Reference is made to the attached drawings wherein like numerals have been applied to like or similar components.

### Brief Description of the Figures

It is shown in
- Fig. 1 a: a schematic cross-sectional side view of an enclosure,
- Fig. 1b: a detail of Fig. 1 showing laser weld lines,
- Fig. 1c: a cross-sectional side view of another embodiment comprising five substrate layers,
- Fig. 2: a schematic top view of an enclosure,
- Fig. 3: a cross-sectional side view along a laser weld line in an enclosure,
- Fig. 4: a cross-sectional view of a laser spot zone,
- Fig. 5: an example of tempering a previous weld line,
- Figs. 6 to 15: an exemplary method of making an enclosure / several enclosures,
- Fig. 16: a cross-sectional side view of an enclosure when tempering the edges of a cavity,
- Fig. 17: a cross-sectional side view of a multi-layered enclosure, where several cavities are arranged in each enclosure,
- Fig. 18: a photography of multiple weld lines in and around the contact surface of two substrates.

### Detailed Description of the Invention

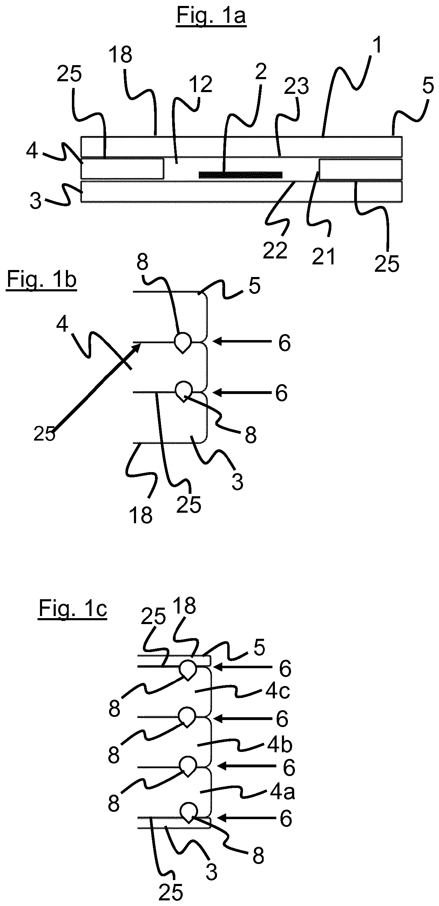

Fig. 1a shows a sectional view of an embodiment of an enclosure. An intermediate layer 4 is arranged on top of the base layer 3, where the function zone 12 is arranged in an intermediate layer 4 of the enclosure 1. On top of the intermediate layer 4 a cover layer 5 is arranged. All of the layers 3,4,5 can also be multi-layered components, e.g. chemically hardened glass with an dielectric coating that covers one or both side partially or wholly. This can also be the case for all of the following descriptions. The function zone 12 is a cavity, where a function component 2 such as an electrical component or lens is situated inside the cavity 12. Between the base layer 3 and the intermediate layer 4 on the one side and the intermediate layer 4 and the cover layer 5 on the other side there is situated a respective contact surface 25. The base layer provides the bottom 22 of the cavity 12, the intermediate layer 4 comprises the side wall 21, where the cover layer 5 comprises the top 23 of the cavity 12.

Referring to Fig. 1b a detail of a corner of the enclosure 1 is shown, where the interface zone 8 welded by a laser beam is shown in more detail. In this embodiment, there is one interface zone 8 in each contact surface 25, where each interface zone 8 is a laser weld line going around the cavity 8. In other words, each interface zone 8 constitutes a circumferentially closed ring or closed line.

Fig. 1c shows another example for an enclosure, where several intermediate layers 4a, 4b, 4c are used, and a stack 18 of layers 3, 4a, 4b, 4c, 5 is formed. Again, at each contact surface 25 there is arranged a respective laser weld line 8. As a result of the laser welding, the respective layer or substrate is firmly bonded or affixed to the neighbouring layer. The top layer 5 of this example might be a glass layer. The intermediate layers 4a, 4b and 4c may also be provided as a multilayer compound 4, and the cavity 12 can then be cleared e.g. by means of an abrasive method.

For example, the base substrate can be a wafer or a printed circuit board, for example made from aluminium nitride. The function zone 12 can also be formed as a recess e.g. in the base layer 3, made e.g. by an abrasive method such as sandblasting.

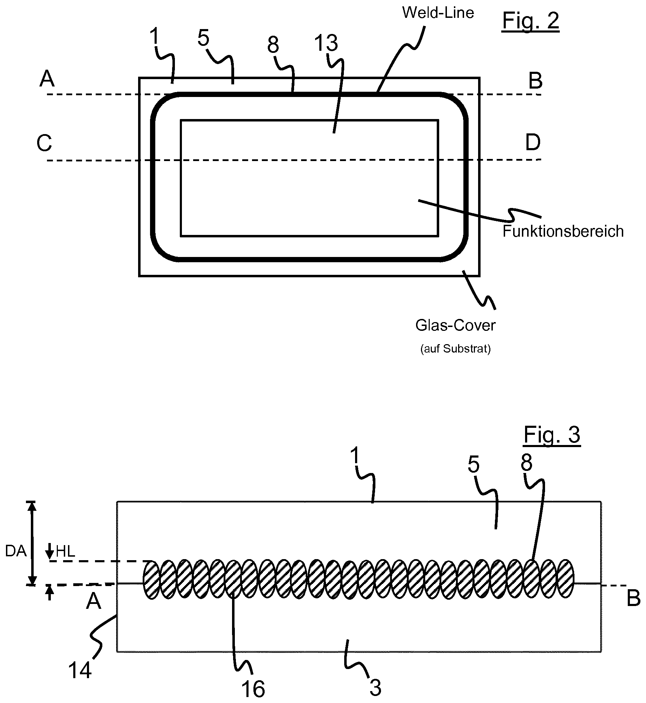

Fig. 2 shows a top view of an enclosure 1 according to the invention, where the circumferential laser weld line 8 encloses the function zone 13. The function zone 13 can be designed to meet different requirements according to the needs, for example this can be an optical receptor, or a technical, electromechanical and/or device 2 arranged in the function zone 13. It is also possible, that several different tasks are accomplished by the function zone 13, e.g. in that different devices 2 are installed in a function zone 13.

Referring to Fig. 3 another sectional view of an embodiment of the enclosure 1 comprising a base layer 3 and a cover layer 5, both in the form of substrates. In other words the enclosure 1 comprises two layers, a base substrate 3 and a cover substrate 5. Further, Fig. 3 indicates how a laser weld line 8 is typically composed, which is, that a multitude of laser pulses 16 is set so close to each other and aligned in the form of a line so that the material of the base substrate 3 and the cover layer 5 melts and merges with each other, preferably without any gap, so that as a result the function zone 13 or the cavity 12 is hermetically sealed by means of the laser weld line 8 or the laser weld lines 8 surrounding the function zone 13 or the cavity 12.

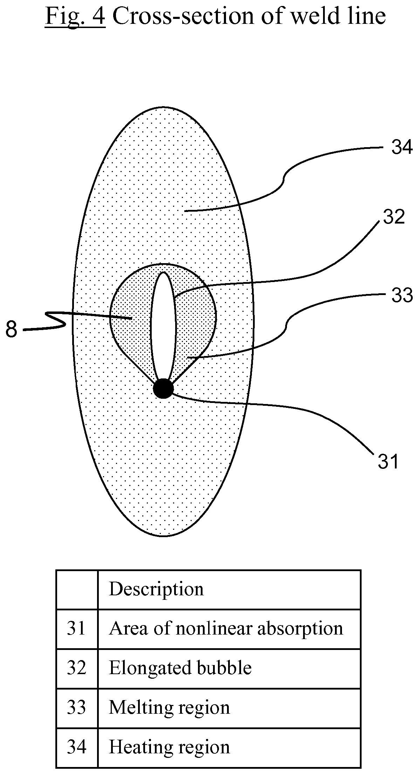

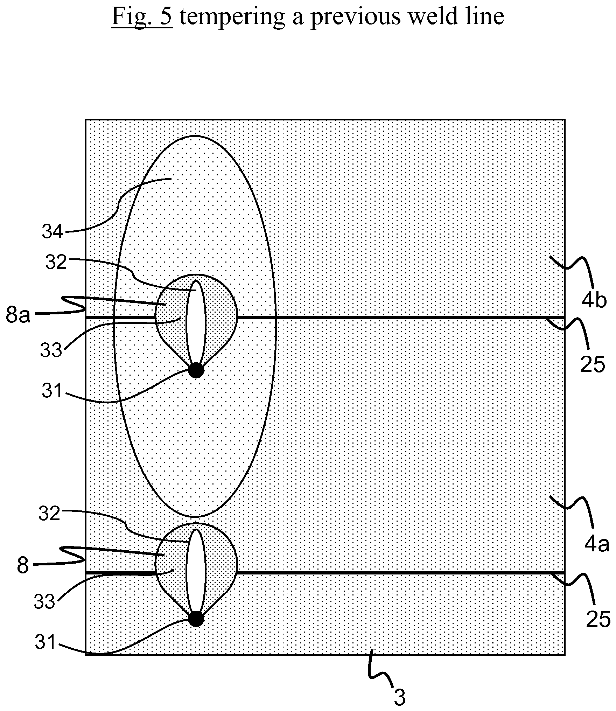

Referring now to Figs. 4 and 5 it is explained how with the introduction of several close laser weld lines 8 the stress in the material of the various substrates 3, 4a, 4b, 5 etc. may be reduced in an inventive manner. Fig. 4 shows a cross-section of a typical weld line 8, which is, the cross-section of a modification caused by several laser pulse shots 16, where the many shots of laser pulses 16 cause through overlapping nonlinear absorption zones a line where heat accumulation takes place and a laser weld line 8 forms. The cross-section through such a weld line is depicted in Fig. 4. It comprises several distinguishable areas. First an area of nonlinear absorption 31, which corresponds more or less with the laser focus and which is in the size of a few micrometre. Above that zone 31 - when the laser 9 is shot from above the substrate stack 18 ,an elongated "bubble-shaped" region 32 (also referred to as "bubble 32" due to its typically quite characteristic shape comparable to an elongated bubble) can be formed which is only a few micrometre in width, but typically up to several tens of micrometre in height. Around that bubble-shaped region 32 there is situated a melting region 33 with a width w and an height h, where temperatures above Tg may be reached and the glass therefore (after cooling or dissipation of warmth) has resolidified. The melting region 33 with the included elongated bubble 32 can usually clearly be identified, e.g., with a light microscope, since its density and with this the refractive index has changed with respect to the surrounding glass. In some cases the area of nonlinear absorption 31 can also be observed as optical damage on the lower tip of the melting region 33.

Around the melting region 33 and in a heated region 34 the glass has received from heat accumulation of the multiple laser shot 9 an amount of energy by means of which its temperature raises to lower than Tg (the melting temperature of the respective material) but still significantly above room temperature. Due to heat diffusion this temperature is not the same in every corner of the heated region 34. The size of the heated region 34 scales with the size of the melting region 33. Thus, the dimensions and in particular the boundary of the melting region 33 can serve as an indicator for the dimensions of the heated region 34.

In the make of the present invention it has been found out that any weld line 8 may also double serve as a local heat source for tempering the substrate material. Tempering is typically known as a heat treatment of glass in order to make it stronger, more resistant to heat and break. This is the same for the tempering presented in this disclosure, but however without the several disadvantages of any tempering method as known in the art. Here, given a certain profile of the weld line 8, which is characterized by height h and width w of the melting region 33, the heat region 34 may be placed by means of a weld line 8 and with respect to the to be tempered region or feature. By means of such a tempering feature, former weld lines 8 may be stress reduced, or even micro-cracks may be removed from the material.

Typical values, which have been found out which serve as an improvement or tempering of the substrate layer material, are presented in table 1 below:

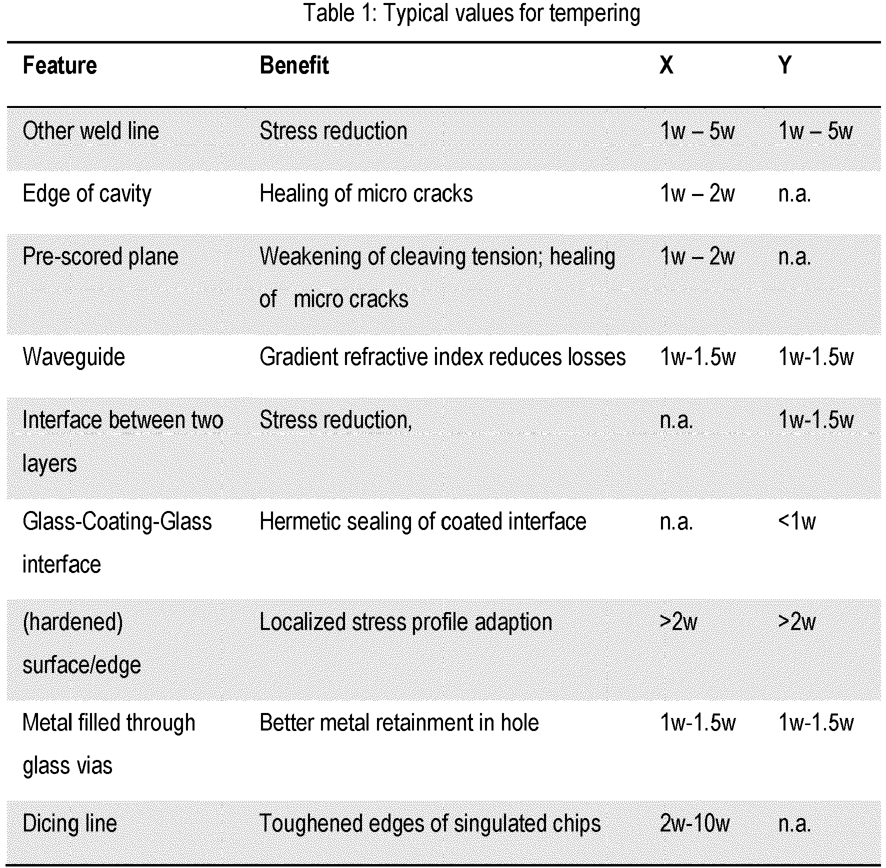

In tab. 1 for different purposes ("feature") the respective benefit which is obtained when tempering is done is indicated. In the third and fourth column, typical values are listed which typical widths may be obtained for the respective zone improved by means of the "laser induced tempering" method presented herein.

For example, for the case that one laser weld line 8 has been shot into a substrate layer, then the material of the respective substrate layer has received an amount of stress which is stored therein. By means of shooting a second laser weld line 8 close to the first one, the stress introduced by the first laser weld line 8 can be reduced, and may even be cancelled out as will be explained further below. In another example given in table 1, when improving an edge of a cavity 12, micro cracks can be eliminated, so that the cavity 12 is more stable and comprises a higher resistance with respect to any forces from outside or inside.

In yet another example given in table 1, in a pre-scored plane cleaving tensions can be healed and at the same time also micro cracks reduced or eliminated. In a waveguide element for example, a gradient refractive index can be set up which may reduce losses of the waveguide.

In an interface between two layers, again stress and micro cracks can be reduced. For example on a glass-coating-class interface, an hermetic sealing of the coated interface can be performed. When the surface or edge has been hardened by other means, e.g. by means of chemical hardening or temperature hardening, or even for any surface or edge, a localized stress adaption profile can be performed in the material. In the case when metal is filled through glass vias a better metal retainment in the hole can be achieved, as given in table 1. And finally, close to any dicing line, the edges of the singulated chips can be toughened.

Referring to Fig. 5, the lower laser weld line 8 has been performed first, and a "curing" second laser weld line 8a has been performed thereafter. Any distortion which had been introduced by the first laser weld line 8 has been neutralized by performing the second laser weld line 8a. In this example, the two laser weld lines 8, 8a achieve the additional feature that substrates are welded together, where the first laser weld line 8 welds the base substrate 3 to the first intermediate layer 4a, and the second laser weld line 8a welds the first intermediate layer 4a with the second intermediate layer 4b along each contacting area 25.

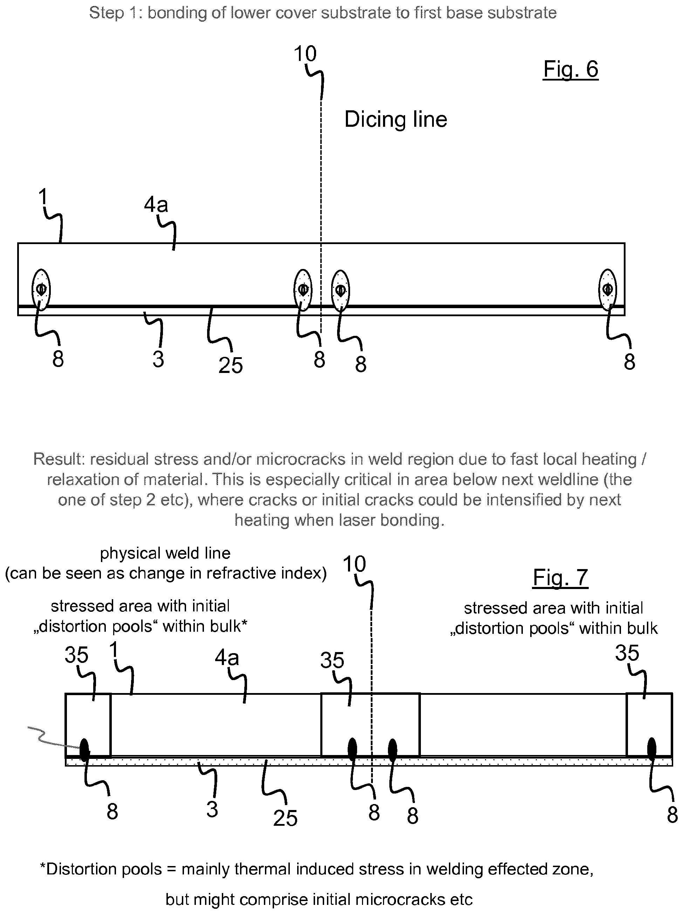

The Figs. 6 to 14 show an exemplary way of composing an enclosure 1 according to the invention, which is also a method of manufacturing the same. The enclosure 1 of this embodiment is covered on both sides by means of a cover substrate which may be thinner than the "inner" substrates, but this is of exemplary reason only. Introducing additional cover substrates on both sides of the template may be advantageous as will be described below in more detail, as has been found out in making the present invention, that by introducing additional cover substrates it can be possible to eliminate even more stress in the materials of the inner substrates.

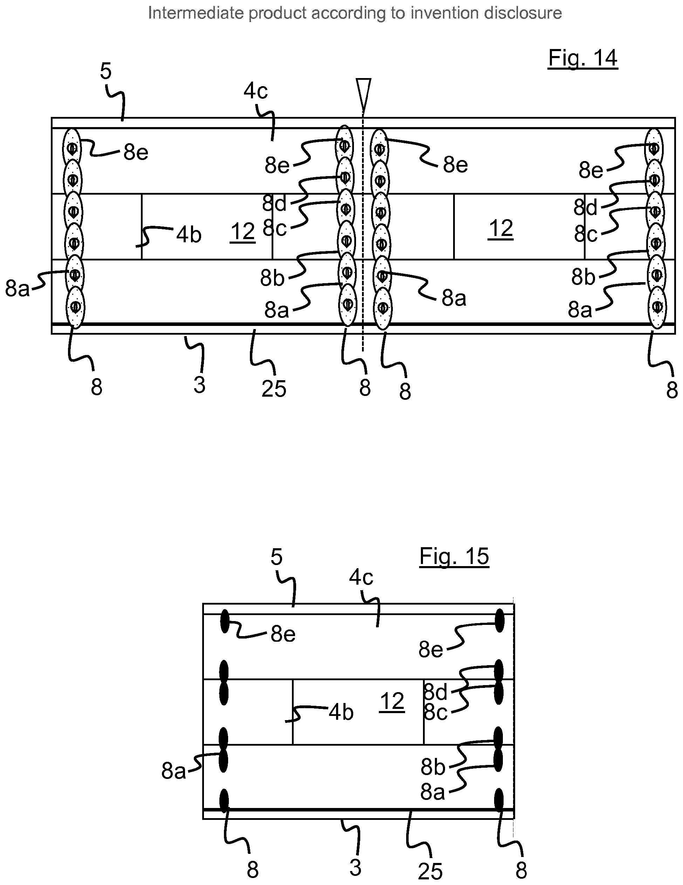

It should be noted that it is not necessary to perform the steps as shown in Figs. 6 to 14 in an isolated manner, but rather that it is possible to provide a full stack 18 as e.g. shown in Fig. 14 and to laser weld each laser weld line 8 in a full stack 18 rather than in a layer-wise manner providing each layer after the next higher layer has been provided.

Additionally, it might be noted, that in Figs. 6 to 14 a number of enclosures 1 - here two enclosures 1 - are prepared and made at the same time with the same process of manufacturing the same, and afterwards the two enclosures 1 are separated from each other along the dicing line 10 indicated e.g. in Fig 6. However, of course each enclosure 1 can also be prepared and made separately.

According to Fig. 6, a lower cover substrate 3 is provided and a first intermediate layer 4a is arranged on top of the lower cover substrate 3. Thus, it could be said that an intermediate product 1 is formed, but in a simple embodiment an enclosure 1 could yet be formed by adjoining two layers and welding each enclosure 1 by at least one laser weld line 8.

Fig. 7 indicates stressed areas 35 in the first intermediate layer 4a, introduced by forming the laser weld line 8 in the material of the enclosure 1. In this example, forming the laser weld line 8 in the material results in residual stress and/or micro cracks in the weld region 35, which occurs due to fast local heating and relaxation of the material and/or due to thermal differences in the material. For reasons of explanation it may be added, that such structurally weak areas 35 can even be worsed when in an area below the next/second weld line cracks or initial cracks could even be intensified.

The "physical" weld line 8, which corresponds to the melting region 33, can be seen by means of a change in the refractive index at its outer circumference. "Above" this physical weld line 8 - when the laser is shot into the material also from above - there occurs the stressed area 35 with an initial "distortion pool". The distortion pool results from mainly thermal induced stress in the welding effected zone 35, but might comprise initial micro cracks or the like.

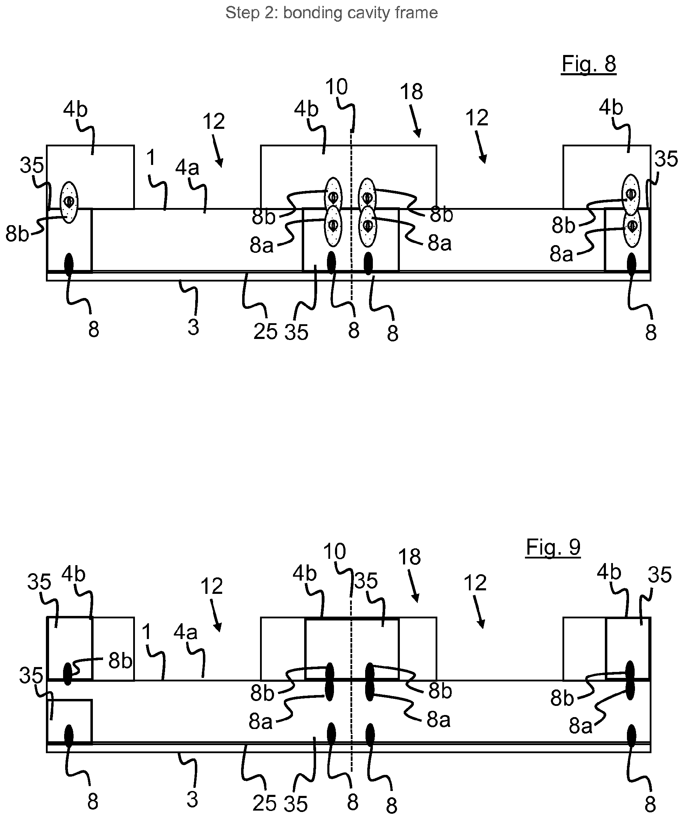

Fig. 8 shows the substrate stack 18 in the moment of placing a second and a third weld line 8a, 8b into the enclosure 1, where a second intermediate layer 4b is arranged on top of the first intermediate layer 4a. The second intermediate layer 4b constitutes the rim 21 or the "frame" of the future cavities 12. The stressed zones 35 are indicated similar to the embodiment of Fig. 7 as in the moment where the embodiment of Fig. 8 is shown the stressed zones 35 still persist, but will decrease thereafter as indicated in Fig. 9. The first weld line 8 has already cooled down, whereas in the second and third "hot" weld lines 8a, 8b still the heating region 34, the elongated bubble 32, the melting region 33 and the area of nonlinear absorption 31 are indicated (see e.g. Fig. 4 for details). The contact surface 25 between the first intermediate layer 4a and the second intermediate layer 4b is welded for the most part by means of the two weld lines 8a and 8b, whereas at the left part of Fig. 8 it is indicated, how the material alters when only one weld line 8a is used.

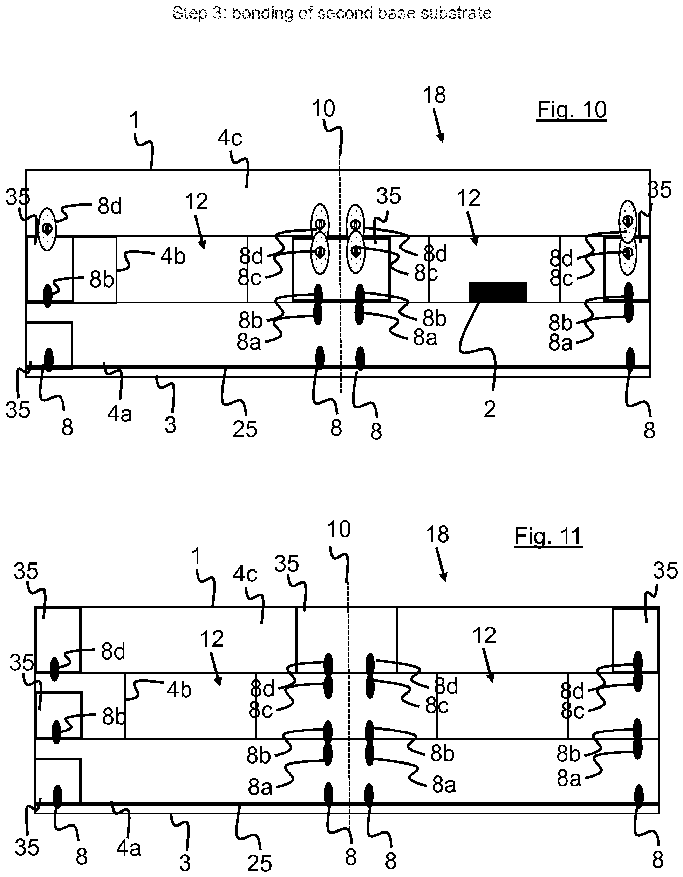

Referring to Fig. 9, the enclosure 1 after the welding step shown in Fig. 8 has cooled down and the stressed areas 35 have evolved. As can be seen in Fig. 8 in the middle and rightmost part, where the two weld lines 8a and 8b have been set, the material of the first intermediate layer 4a is stress-free. It has been found out that if the two weld lines 8a, 8b are set close to each other, e.g. one below and one above a contact surface 25 which is to be welded, that then the stress and even the maybe present micro cracks can be "cured" in the material around the welding zones. This is of particular interest, as the contact surfaces 25 in between any substrate layer of the stack 18 / the enclosure 1 typically constitutes one of the most critical areas with respect to its integral stability. Now new stressed zones 35 have evolved in the second intermediate layer 4b surrounding the later-to-be cavities 12; these stressed zones 35 can be relieved of stress in a subsequent step (see Fig. 10).

Reverting now to the left part of Fig. 9 only one second weld line 8a has been introduced here in the material. In this area, stress persists in the material of the first intermediate layer 4a thus resulting in a weaker material composition, which is, worse withstanding any bending forces or impacts, where even micro cracks may persist.

Fig. 10 shows a next consecutive step of manufacturing an enclosure 1 according to the invention. A third intermediate layer 4c is positioned on top of the second intermediate layer 4b so as to close the cavities 12. If any electronics or function component 2 should be inserted into the cavity 12 or the function zone 13, then in this exemplary method of manufacturing an enclosure 1 it should be added prior to the step shown in Fig. 10. By means of exemplary reasons, the left cavity 12 comprises a function component 2. A third and fourth laser weld line 8c and 8d has been shot at the enclosure 1 leaving a relatively hot zone, which has yet to cool down. The stress zones 35 indicated in this example correspond to those shown in Fig. 9, as the laser weld zones are still hot and the stress relief in the respective zones did not yet has come to pass. The contact surface 25 between the second and third intermediate layers 4b, 4c has been welded with the two laser weld lines 8c and 8d.

As can be retrieved from Fig. 11, the stress zones 35 in the middlemost and right part of the figure have disappeared, meaning that the stress has been reduced or eliminated in the material of the enclosure 1. But in the left part of Fig. 11, which is shown for comparative reasons only, where each contact surface 25 has only been welded with each one laser weld line 8b, 8d stress persists in the material, as is indicated with the stress zones 35 which also remain in the first and second intermediate layer 4a, 4b.

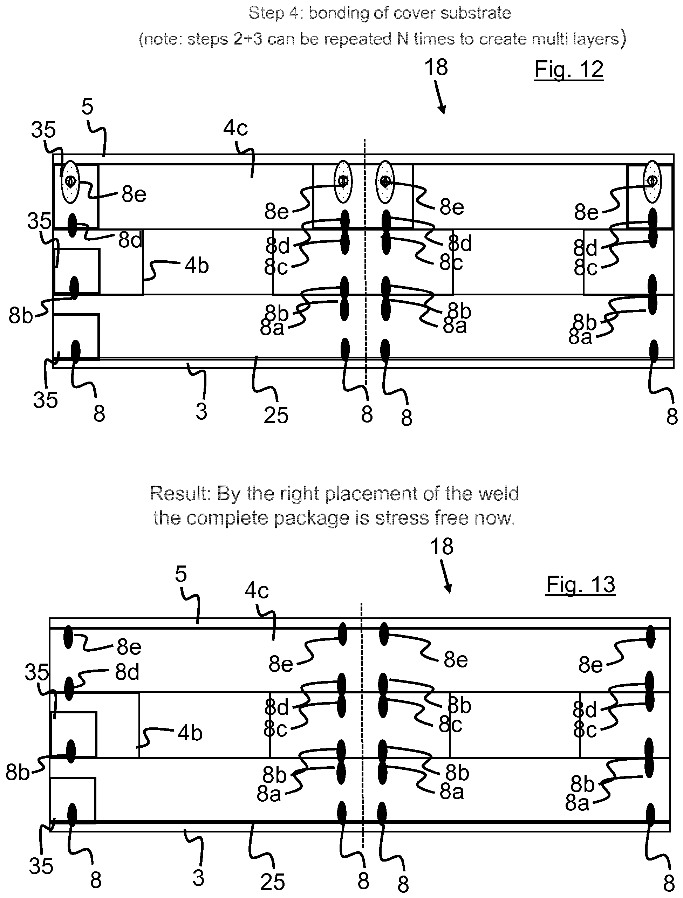

Referring now to Fig. 12 a consecutive step for making an enclosure 1 according to the invention is shown, where an upper cover layer 5 is arranged above the third intermediate layer 4c and welded to the same with one additional weld line 8e; Again, the very moment when the laser is shot into the material of the enclosures 1 is indicated with Fig. 12, so that the stress zones 35 are the same with respect to the situation shown in Fig. 11. A full stack 18 of substrates is finished. In Fig. 13, the resulting stress relief can be seen, as in the middle part and the right part no stress zones 35 remain. In the left part, which again is indicated only for comparative reasons, in order to easier understand the reasons, and where only one laser weld line 8 is used for welding each contact surface 25, still stress zones 35 persist in the material, thus weakening the same. But in the third intermediate layer 4c, where two laser weld lines 8d and 8e are situated, a full stress relief can be achieved. As is now clear from Fig. 13 and the before-mentioned explanations, the bottom and top cover layers 3 and 5 allow in the end for an enclosure, which gains benefit from all advantages of being laser welded, but which does not suffer from additional stress in the material. The material is tempered, so that micro cracks are equalled, but without the disadvantages of classical tempering methods. For example, electronics or function components 2 can be installed in the enclosure 1, which would not be possible with normal tempering due to the necessary high temperatures throughout the whole material of the enclosure 1. But however, the outermost layers, which are the lower cover layer 3 and the upper cover layer 5, can for example be tempered (which is: relieved of stress) by means of classical methods, which is, by means of heating up the layers 3, 5 above a melting temperature.

Referring now to Fig. 14 an embodiment is shown, where a full stack 18 of substrates 3, 4a, 4b, 4c and 5 is arranged on each other, where the laser weld lines 8, 8a, 8b, 8c, 8d and 8e are introduced into the material one after another. Finally, the two enclosures 1 are cut or separated along the dicing line 10, and with Fig. 15 a single enclosure 1 is shown which can be obtained with the above explained method of manufacturing the same.

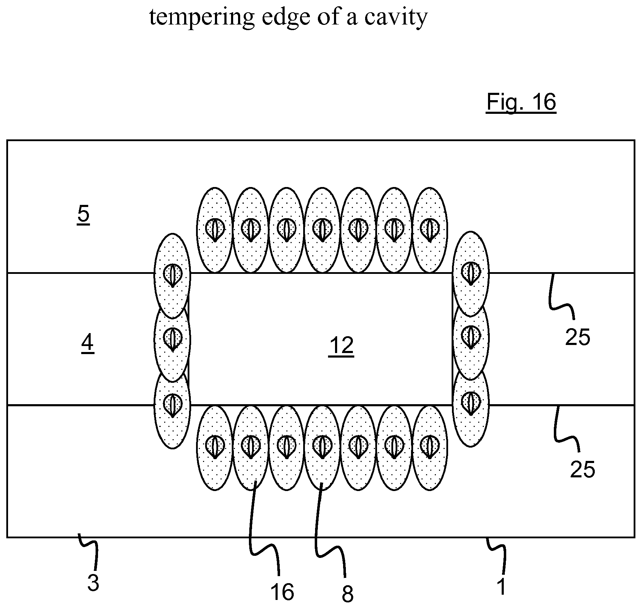

With Fig. 16 another example of tempering around the edge of a cavity 12 is shown. An at least two-dimensional weld line 8 is performed around the cavity 12, where by means of the laser weld line 8 not only the formerly separated substrates 3, 4 and 5 are welded together, but also any stress in the zone surrounding the cavity 12 is eliminated or at least significantly reduced, including elimination of possible micro cracks. Such micro cracks can be persistent in the material, or be brought in the material e.g. when cutting out material for making the cavity 12. A subsequent line of laser shots 16 is set close to each other to build the laser weld line 8 around the cavity 12.

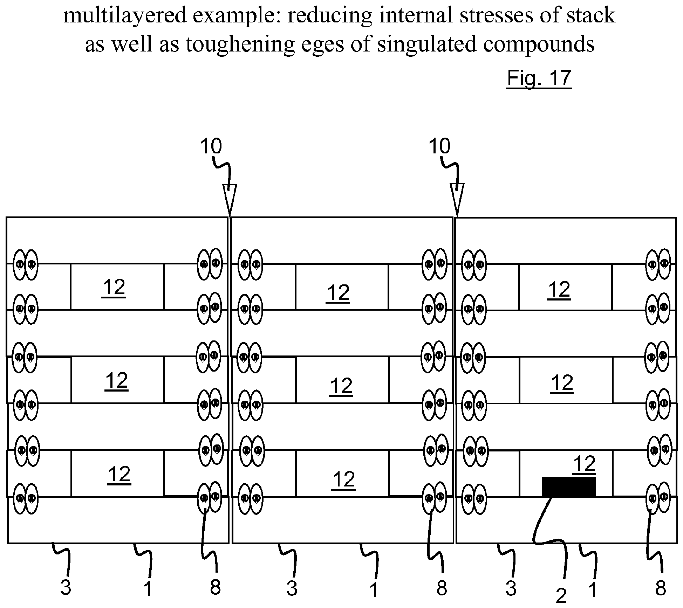

Referring to Fig. 17 a multi-layered example is shown, where each enclosure 1 comprises three cavities 12, and at the same time where three enclosures 1 are made together in the same manufacturing process, but are separated in a separation step after finishing laser welding for example along the dicing lines 10 indicated in Fig. 17. Several laser weld lines 8 are introduced into the material as described above in order to eliminate or decrease stress in the material of the enclosures 1. Each cavity 12 typically comprises a function component 2, whereas such a function component 2 is indicated in one cavity 12 only for reasons of ease of understanding.

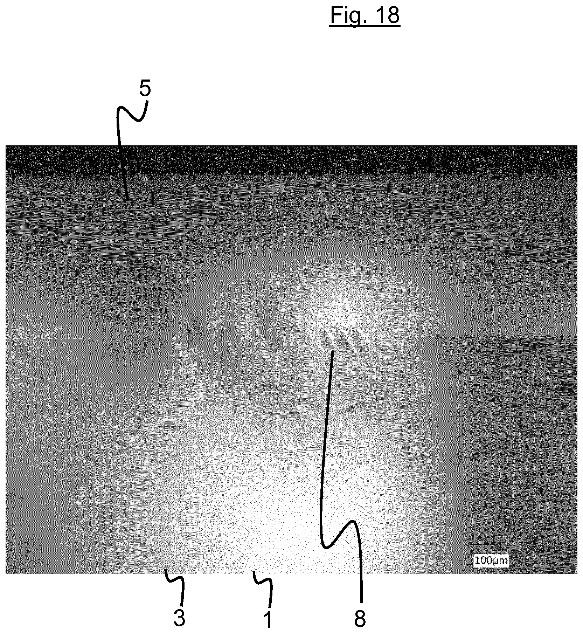

Fig. 18 shows a photography of two substrates 3 and 5 laser welded together along a laser weld line 8, where the change in refractive property can be seen as well as the reduction of stress in the material, which shall serve as proof-of-principle of the above-indicated method and enclosure 1.

It will be appreciated that the features defined herein in accordance with any aspect of the present invention or in relation to any specific embodiment of the invention may be utilized, either alone or in combination with any other feature or aspect of the invention or embodiment. In particular, the present invention is intended to cover an enclosure 1 and/or a method of manufacturing an enclosure 1 configured to include any feature described herein. It will be generally appreciated that any feature disclosed herein may be an essential feature of the invention alone, even if disclosed in combination with other features, irrespective of whether disclosed in the description, the claims and/or the drawings.

### List of reference signs:

- 1: enclosure
- 2: device or function component
- 3: lower substrate, base layer or lower cover substrate
- 4, 4a, 4b: intermediate layer or multilayer compound
- 4c: intermediate layer
- 5: upper cover layer, cover substrate
- 8, 8a, 8b, 8c, 8d, 8e,: laser weld line
- 9: focussed laser beam
- 10: dicing line
- 12: cavity
- 13: function zone
- 14: edge
- 15: laser unit
- 16: laser pulse
- 18: stack of substrates; wafer stack
- 21: edge/rim of cavity
- 22: bottom of cavity
- 23: top of cavity
- 25: contact surface
- 31: area of nonlinear absorption
- 32: elongated bubble
- 33: melting region
- 34: heating region
- 35: stressed area

## Claims

1. An enclosure (1), comprising:
at least a base substrate (3) and a cover substrate (5), which constitute at least a part of the enclosure, wherein the enclosure (1) either comprises the base substrate (3) and the cover substrate (5) as two layers or wherein the enclosure further comprises at least one intermediate layer (4, 4a, 4b, 4c, 4d, 4e) positioned in between the base layer (3) and the cover layer (5);
a function zone (12, 13) situated such that it is at least partly enclosed in the enclosure;
wherein at least the cover substrate comprises a glass or glass-like material or a silicon based material and wherein preferably also the base substrate comprises a glass or glass-like material or a silicon based material;
wherein the base substrate and the cover substrate are welded by means of at least one laser weld line (8);
where the laser weld line comprises a height HL in a direction perpendicular to its connecting plane,
wherein the enclosure comprises at least a second laser weld line (8a, 8b, 8c, 8d, 8e, 8f) situated next to the first laser weld line and/or situated such that the mechanical stress in the at least one laser weld line is reduced by means of the second laser weld line, thus improving the mechanical stability of the enclosure.

2. The enclosure (1) according to the preceding claim,
wherein the mechanical stress in the at least one laser weld line (8) is reduced by means of a stress reduction process step, and/or by means of a crack reduction step.

3. The enclosure (1) according to claim 1 or 2,
wherein the first laser weld line (8) introduces a stress zone (35) in the enclosure,
wherein the second laser weld line (8a, 8b, 8c, 8d, 8e, 8f) is positioned in or next to the stress zone induced by the first laser weld line, and
wherein the second laser weld line relieves the stress zone so that a stress-free or nearly stress-free zone is established, and/or so that the laser welded enclosure is stress-free or nearly stress-free.

4. The enclosure (1) according to at least one of the preceding claims, further comprising a cavity (12) inside the enclosure or wherein the function zone (13) is said cavity,
further comprising an at least two dimensional laser weld line (8) around the cavity for tempering the edges of the cavity.

5. The enclosure (1) according to at least one of the preceding claims, wherein the at least one laser bond line (8, 8a, 8b, 8c, 8d, 8e, 8f) circumferes the function zone (12, 13) in a distance DF, where the distance corresponds, for example, to the height HF or less, or corresponds to double the height HF or less.

6. The enclosure (1) according to at least one of the preceding claims,
the enclosure providing hermetical sealing for the function zone, so that the enclosure is a hermetically sealed enclosure; and/or
wherein the function zone (13) is circumferentially enclosed in the enclosure.

7. The enclosure (1) according to at least one of the preceding claims,
further comprising an elastic or flexible layer (4a, 4b, 4c, 4d), so that the enclosure is deformable e.g. by means of pressure change or by means of a mechanical force.

8. The enclosure (1) according to at least one of the preceding claims, further comprising an inner coating zone (36), positioned for example around the function zone (12, 13).

9. The enclosure (1) according to at least one of the preceding claims, wherein at least one of the substrates of the enclosure is provided as a multilayer compound (4), for example comprising one or more coating layers or pre-stress zones and/or providing one or more substrates.

10. The enclosure (1) according to at least one of the preceding claims, wherein the intermediate layer is provided as a multilayer compound.

11. The enclosure (1) according to at least one of the preceding claims, wherein the function zone (12, 13) is situated in the or one of the intermediate layer(s) (4, 4a, 4b, 4c, 4d, 4e) and is covered by said base layer (3) on its bottom side and by said cover layer (5) on its top side.

12. The enclosure (1) according to at least one of the preceding claims, wherein the function zone (12, 13) is a cavity (12) and wherein a function component (2) such as an electrical component is arranged in said cavity to be protected by the enclosure.

13. The enclosure (1) according to the preceding claim, wherein the function component (2) comprises a power semiconductor, such as a GaN-LED, a SiC-, GaAs- or GaN- power transistor being positioned inside the cavity (12).

14. The enclosure (1) according to at least one of the preceding claims, wherein each laser bond line (8, 8a, 8b, 8c, 8d, 8e, 8f) is situated such that it extends into two different substrates (3, 4a, 4b, 4c, 4d, 4e, 4f, 5) of the enclosure, wherein for example the laser bond line extends from the base cover layer (3) into the top cover layer (5), and wherein the laser bond line welds the two different substrates with each other.

15. The enclosure (1) according to at least one of the preceding claims, wherein the substrates (3, 4a, 4b, 4c, 4d, 4e, 4f, 5) comprise a thickness of below 3 mm, preferably below 1500 µm, preferably below 500 µm, preferably below 120 µm and further preferably below 80 µm, and/or
wherein the base cover layer (3) and/or the top cover layer (5) is thinner than the one or more intermediate layers (4a, 4b, 4c, 4d, 4e, 4f), for example comprising half the width of the intermediate layers or less.

16. The enclosure (1) according to at least one of the preceding claims, wherein at least one of the substrate layers (3, 4a, 4b, 4c, 4d, 4e, 4f, 5), for example the base cover layer (3), comprises through vias for electrically contacting the function zone (12, 13) with the surrounding outside of the enclosure, for example a contact pad on the lower side of the base cover layer.

17. The enclosure (1) according to at least one of the preceding claims, wherein the enclosure comprises a size of 10mm x 10mm or less, preferably 5mm x 5mm or less, further preferably 2mm x 2mm or 1mm x 1mm or less, and/or
wherein the enclosure comprises an height which is greater than its width.

18. Use of an enclosure (1) according to at least one of the preceding claims for making a medical implant, a micro lens compound, a micro optical chip, a pharma packaging, an LED or an optical assembly for an augmented reality device.

19. Method of providing an enclosure (1)as claimed in any of the preceding claims, wherein the enclosure encloses a function zone (12, 13) such as a cavity (12), the method comprising the steps:
providing a base substrate (3) and aligning a cover substrate (5) above the base substrate in such a way, that at least one contact surface (25) is arranged between the base substrate and the cover substrate,
hermetically sealing the function zone by means of introducing a first laser weld line (8) in the enclosure,
introducing a second laser weld line (8a, 8b, 8c, 8d, 8e, 8f) at the same position as the first laser weld-line or at a position close to or overlapping with the first laser weld line, and
relieving stress in the area of the first laser weld line of the enclosure by means of introducing said second laser weld line,
wherein at least the cover substrate comprises a glass or glass-like material or a silicon based material and wherein preferably also the base substrate comprises a glass or glass-like material or a silicon based material.

20. The method of providing a enclosure (1) as claimed in the preceding claim,
wherein a laser beam source (9) is used to introduce the laser weld lines (8, 8a, 8b, 8c, 8d, 8e, 8f), into the enclosure; and
wherein the laser beam is guided around the function zone (12, 13) for making the laser weld line along the contact area (25) between the base substrate (3) and the cover substrate (5).

21. The method as defined in the preceding claim, wherein the laser source (9) is a pulsed laser source and wherein several laser pulses are introduced along the laser weld line (8, 8a, 8b, 8c, 8d, 8e, 8f), so that a continuous or continuous-like weld-line is composed from the several laser pulses.

22. Tempered sealed enclosure (1) made by the method as claimed in any of the preceding method claims.

## Patentansprüche

1. Umhäusung (1), umfassend:
mindestens ein Basissubstrat (3) und ein Abdecksubstrat (5), die zumindest einen Teil der Umhäusung bilden, wobei die Umhäusung (1) entweder das Basissubstrat (3) und das Abdecksubstrat (5) als zwei Schichten umfasst oder wobei die Umhäusung ferner mindestens eine Zwischenschicht (4, 4a, 4b, 4c, 4d, 4e) umfasst, die zwischen der Basisschicht (3) und der Abdeckschicht (5) angeordnet ist,
einen Funktionsbereich (12, 13), welcher derart angeordnet ist, dass er zumindest teilweise in der Umhäusung eingeschlossen ist,
wobei zumindest das Abdecksubstrat ein Glas oder ein glasartiges Material oder ein Material auf Siliziumbasis umfasst und wobei vorzugsweise auch das Basissubstrat ein Glas oder ein glasartiges Material oder ein Material auf Siliziumbasis umfasst,
wobei das Basissubstrat und das Abdecksubstrat mittels mindestens einer Laserbondlinie (8) verschweißt sind,
wobei die Laserbondlinie eine Höhe HL in einer Richtung senkrecht zu ihrer Verbindungsebene aufweist,
wobei die Umhäusung mindestens eine zweite Laserbondlinie (8a, 8b, 8c, 8d, 8e, 8f) umfasst, die neben der ersten Laserbondlinie angeordnet ist und/oder derart angeordnet ist, dass die mechanische Spannung in der mindestens einen Laserbondlinie mittels der zweiten Laserbondlinie reduziert wird, wodurch die mechanische Stabilität der Umhäusung verbessert ist.

2. Umhäusung (1) gemäß dem vorhergehenden Anspruch,
wobei die mechanische Spannung in der mindestens einen Laserbondlinie (8) mittels eines Prozessschrittes zu Spannungsreduktion und/oder mittels eines Schrittes zur Rissreduktion reduziert wird.

3. Umhäusung (1) nach Anspruch 1 oder 2,
wobei die erste Laserbondlinie (8) eine Spannungszone (35) in die Umhäusung einbringt,
wobei die zweite Laserbondlinie (8a, 8b, 8c, 8d, 8e, 8f) in oder neben der durch die erste Laserbondlinie eingebrachten Spannungszone angeordnet ist und
wobei die zweite Laserbondlinie die Spannungszone entlastet, so dass eine spannungsfreie oder nahezu spannungsfreie Zone entsteht und/oder so dass die laserverschweißte Umhäusung spannungsfrei oder nahezu spannungsfrei ist.

4. Umhäusung (1) nach mindestens einem der vorhergehenden Ansprüche, ferner mit einem Hohlraum (12) im Inneren der Umhäusung, wobei der Funktionsbereich (13) diesen Hohlraum darstellt, ferner umfassend eine mindestens zweidimensionale Laserbondlinie (8) um den Hohlraum herum zum Tempern der Kanten des Hohlraums.

5. Umhäusung (1) nach mindestens einem der vorhergehenden Ansprüche, wobei die mindestens eine Laserbondlinie (8, 8a, 8b, 8c, 8d, 8e, 8f) den Funktionsbereich (12, 13) in einem Abstand DF umläuft, wobei der Abstand beispielsweise der Höhe HF oder weniger entspricht, oder der doppelten Höhe HF oder weniger entspricht.

6. Umhäusung (1) nach mindestens einem der vorhergehenden Ansprüche,
wobei die Umhäusung eine hermetische Abdichtung für den Funktionsbereich bietet, so dass es sich bei der Umhäusung um eine hermetisch abgedichtete Umhäusung handelt, und/oder
wobei der Funktionsbereich (13) umlaufend von der Umhäusung eingeschlossen ist.

7. Umhäusung (1) nach mindestens einem der vorhergehenden Ansprüche,
ferner mit einer elastischen oder flexiblen Schicht (4a, 4b, 4c, 4d), so dass die Umhäusung verformbar ist, beispielsweise durch Druckänderung oder durch mechanische Kraft.

8. Umhäusung (1) nach mindestens einem der vorhergehenden Ansprüche, ferner mit einem innerem Beschichtungsbereich (36), der beispielsweise um den Funktionsbereich (12, 13) herum angeordnet ist.

9. Umhäusung (1) nach mindestens einem der vorhergehenden Ansprüche, wobei mindestens eines der Substrate der Umhäusung als Mehrschichtverbund (4) ausgebildet ist, beispielsweise mit einer oder mehreren Beschichtungslagen oder Vorspannungszonen und/oder einem oder mehreren Substraten.

10. Umhäusung (1) nach mindestens einem der vorhergehenden Ansprüche, wobei die Zwischenschicht als Mehrschichtverbund ausgebildet ist.

11. Umhäusung (1) nach mindestens einem der vorhergehenden Ansprüche, wobei sich der Funktionsbereich (12, 13) in der oder einer der Zwischenschichten (4, 4a, 4b, 4c, 4d, 4e) befindet und an seiner Unterseite durch die Basisschicht (3) und an seiner Oberseite durch die Abdeckschicht (5) abgedeckt ist.

12. Umhäusung (1) nach mindestens einem der vorhergehenden Ansprüche, wobei der Funktionsbereich (12, 13) ein Hohlraum (12) ist und wobei eine Funktionskomponente (2) wie beispielsweise ein elektrisches Bauelement in dem Hohlraum angeordnet ist, um durch die Umhäusung geschützt zu sein.

13. Umhäusung (1) gemäß dem vorhergehenden Anspruch, wobei die Funktionskomponente (2) einen im Inneren des Hohlraums (12) angeordneten Leistungshalbleiter umfasst, beispielsweise eine GaN-LED, einen SiC-, GaAs- oder GaN-Leistungstransistor.

14. Umhäusung (1) nach mindestens einem der vorhergehenden Ansprüche, wobei die Laserbondlinie (8, 8a, 8b, 8c, 8d, 8e, 8f) jeweils derart angeordnet ist, dass sie sich in zwei unterschiedliche Substrate (3, 4a, 4b, 4c, 4d, 4e, 4f, 5) der Umhäusung hinein erstreckt, wobei sich die Laserbondlinie beispielsweise von der Basisabdeckschicht (3) in die obere Abdeckschicht (5) hinein erstreckt und wobei die Laserbondlinie die beiden unterschiedlichen Substrate miteinander verschweißt.

15. Umhäusung (1) nach mindestens einem der vorhergehenden Ansprüche,
wobei die Substrate (3, 4a, 4b, 4c, 4d, 4e, 4f, 5) eine Dicke von weniger als 3 mm aufweisen, vorzugsweise von weniger als 1500 µm, vorzugsweise von weniger als 500 µm, vorzugsweise von weniger als 120 µm und weiter bevorzugt von weniger als 80 µm, und/oder
wobei die Basisabdeckschicht (3) und/oder die obere Abdeckschicht (5) dünner ist/sind als die eine oder die mehreren Zwischenschichten (4a, 4b, 4c, 4d, 4e, 4f), beispielsweise halb so dick wie die Zwischenschichten oder dünner.

16. Umhäusung (1) nach mindestens einem der vorhergehenden Ansprüche, wobei mindestens eine der Substratlagen (3, 4a, 4b, 4c, 4d, 4e, 4f, 5), beispielsweise die Basisabdeckschicht (3), Durchkontaktierungen zur elektrischen Kontaktierung des Funktionsbereichs (12, 13) mit der umgebenden Außenseite der Umhäusung, beispielsweise einem Kontaktpad auf der Unterseite der Basisabdeckschicht, umfasst.

17. Umhäusung (1) nach mindestens einem der vorhergehenden Ansprüche,
wobei die Umhäusung eine Größe von 10 mm x 10 mm oder weniger, vorzugsweise 5 mm x 5 mm oder weniger, weiter bevorzugt von 2 mm x 2 mm oder 1 mm x 1 mm oder weniger aufweist, und/oder
wobei die Umhäusung eine Höhe aufweist, die größer ist als ihre Breite.

18. Verwendung einer Umhäusung (1) nach mindestens einem der vorhergehenden Ansprüche zur Herstellung eines medizinischen Implantats, eines Mikrolinsenverbunds, eines mikrooptischen Chips, einer pharmazeutischen Verpackung, einer LED oder einer optischen Baugruppe für ein Augmented-Reality-Gerät.

19. Verfahren zum Bereitstellen einer Umhäusung (1) nach einem der vorhergehenden Ansprüche, wobei die Umhäusung einen Funktionsbereich (12, 13) wie etwa einen Hohlraum (12) umschließt, wobei das Verfahren die folgenden Schritte umfasst:
Bereitstellen eines Basissubstrats (3) und Ausrichten eines Abdecksubstrats (5) über dem Basissubstrat in solcher Weise, dass sich zwischen dem Basissubstrat und dem Abdecksubstrat zumindest eine Kontaktfläche (25) befindet,
hermetisches Abdichten des Funktionsbereichs durch Einbringen einer ersten Laserbondlinie (8) in die Umhäusung,
Einbringen einer zweiten Laserbondlinie (8a, 8b, 8c, 8d, 8e, 8f) an der gleichen Stelle wie die erste Laserbondlinie oder an einer Stelle nahe der ersten Laserbondlinie oder mit dieser überlappend, und Entlasten der Spannung in dem Bereich der ersten Laserbondlinie der Umhäusung durch Einbringen der zweiten Laserbondlinie,
wobei zumindest das Abdecksubstrat ein Glas oder ein glasartiges Material oder ein Material auf Siliziumbasis umfasst und wobei vorzugsweise auch das Basissubstrat ein Glas oder ein glasartiges Material oder ein Material auf Siliziumbasis umfasst.

20. Verfahren zum Bereitstellen einer Umhäusung (1) gemäß dem vorhergehenden Anspruch,
wobei eine Laserstrahlquelle (9) verwendet wird, um die Laserbondlinien (8, 8a, 8b, 8c, 8d, 8e, 8f) in die Umhäusung einzubringen, und
wobei der Laserstrahl um den Funktionsbereich (12, 13) herum geführt wird, um die Laserbondlinie entlang der Kontaktfläche (25) zwischen dem Basissubstrat (3) und dem Abdecksubstrat (5) zu erzeugen.

21. Verfahren gemäß dem vorhergehenden Anspruch, wobei die Laserquelle (9) eine gepulste Laserquelle ist und wobei mehrere Laserimpulse entlang der Laserbondlinie (8, 8a, 8b, 8c, 8d, 8e, 8f) eingebracht werden, so dass aus den mehreren Laserimpulsen eine durchgehende oder nahezu durchgehende Bondlinie zusammengesetzt wird.

22. Getemperte abgedichtete Umhäusung (1), hergestellt mit dem Verfahren gemäß einem der vorhergehenden Verfahrensansprüche.

## Revendications

1. Enceinte (1) comprenant :
au moins un substrat de base (3) et un substrat de couverture (5), qui constituent au moins une partie de l'enceinte, dans laquelle l'enceinte (1) comprend soit le substrat de base (3) et le substrat de couverture (5) sous la forme de deux couches, soit dans laquelle l'enceinte comprend en outre au moins une couche intermédiaire (4, 4a, 4b, 4c, 4d, 4e) positionnée entre la couche de base (3) et la couche de couverture (5) ;
une zone de fonction (12, 13) située de telle manière qu'elle est au moins partiellement enfermée dans l'enceinte ;
dans laquelle au moins le substrat de couverture comprend un verre ou un matériau de type verre ou un matériau à base de silicium et dans laquelle de préférence le substrat de base comprend aussi un verre ou un matériau de type verre ou un matériau à base de silicium ;
dans laquelle le substrat de base et le substrat de couverture sont soudés au moyen d'au moins une ligne de soudure au laser (8) ;
dans laquelle la ligne de soudure au laser comprend une hauteur HL dans une direction perpendiculaire à son plan de connexion,
dans laquelle l'enceinte comprend au moins une deuxième ligne de soudure au laser (8a, 8b, 8c, 8d, 8e, 8f) située près de la première ligne de soudure au laser et/ou située de telle manière que la contrainte mécanique dans ladite au moins une ligne de soudure au laser est réduite grâce à la deuxième ligne de soudure au laser, améliorant ainsi la stabilité mécanique de l'enceinte.

2. Enceinte (1) selon la revendication précédente, dans laquelle la contrainte mécanique dans ladite au moins une ligne de soudure au laser (8) est réduite au moyen d'une étape de processus de réduction de contrainte, et/ou au moyen d'une étape de réduction de fissure.

3. Enceinte (1) selon la revendication 1 ou 2,
dans laquelle la première ligne de soudure au laser (8) introduit une zone de contrainte (35) dans l'enceinte,
dans laquelle la deuxième ligne de soudure au laser (8a, 8b, 8c, 8d, 8e, 8f) est positionnée dans ou près de la zone de contrainte induite par la première ligne de soudure au laser, et
dans laquelle la deuxième ligne de soudure au laser soulage la zone de contrainte, de sorte qu'une zone sans contrainte ou presque sans contrainte est établie, et/ou de sorte que l'enceinte soudée au laser est sans contrainte ou presque sans contrainte.

4. Enceinte (1) selon au moins l'une des revendications précédentes, comprenant en outre une cavité (12) à l'intérieur de l'enceinte ou dans laquelle la zone de fonction (13) est ladite cavité, comprenant en outre une ligne de soudure au laser au moins bidimensionnelle (8) autour de la cavité pour adoucir les bords de la cavité.

5. Enceinte (1) selon au moins l'une des revendications précédentes, dans laquelle ladite au moins une ligne de soudure au laser (8, 8a, 8b, 8c, 8d, 8e, 8f) circonscrit la zone de fonction (12, 13) à une distance DF, cette distance correspondant, par exemple, à la hauteur HF ou moins, ou correspondant au double de la hauteur HF ou moins.

6. Enceinte (1) selon au moins l'une des revendications précédentes,
l'enceinte fournissant une étanchéité pour la zone de fonction, de sorte que l'enceinte est une enceinte hermétique ; et/ou
dans laquelle la zone de fonction (13) est enfermée de façon circonférentielle dans l'enceinte.

7. Enceinte (1) selon au moins l'une des revendications précédentes, comprenant en outre une couche élastique ou flexible (4a, 4b, 4c, 4d), de sorte que l'enceinte est déformable par exemple par une variation de pression ou au moyen d'une force mécanique.

8. Enceinte (1) selon au moins l'une des revendications précédentes, comprenant en outre une zone de revêtement intérieur (36), positionnée par exemple autour de la zone de fonction (12, 13).

9. Enceinte (1) selon au moins l'une des revendications précédentes, dans laquelle au moins l'un des substrats de l'enceinte est fourni sous la forme d'un composé multicouche (4), comprenant par exemple une ou plusieurs couches de revêtement ou zones de précontrainte et/ou fournissant un ou plusieurs substrats.

10. Enceinte (1) selon au moins l'une des revendications précédentes, dans laquelle la couche intermédiaire est fournie sous la forme d'un composé multicouche.

11. Enceinte (1) selon au moins l'une des revendications précédentes, dans laquelle la zone de fonction (12, 13) est située dans la ou l'une des couche(s) intermédiaire(s) (4, 4a, 4b, 4c, 4d, 4e) et est couverte par ladite couche de base (3) sur son côté inférieur et par ladite couche de couverture (5) sur son côté supérieur.

12. Enceinte (1) selon au moins l'une des revendications précédentes, dans laquelle la zone de fonction (12, 13) est une cavité (12) et dans laquelle un composant de fonction (2) tel qu'un composant électrique est placé dans ladite cavité pour être protégé par l'enceinte.

13. Enceinte (1) selon la revendication précédente, dans laquelle le composant de fonction (2) comprend un semiconducteur de puissance, tel qu'une diode électroluminescente GaN, un transistor de puissance SiC, GaAs ou GaN, positionné à l'intérieur de la cavité (12).

14. Enceinte (1) selon au moins l'une des revendications précédentes, dans laquelle chaque ligne de soudure au laser (8, 8a, 8b, 8c, 8d, 8e, 8f) est située de telle manière qu'elle s'étend dans deux substrats différents (3, 4a, 4b, 4c, 4d, 4e, 4f, 5) de l'enceinte, dans laquelle par exemple la ligne de soudure au laser s'étend de la couche de couverture de base (3) à la couche de couverture supérieure (5), et dans laquelle la ligne de soudure au laser lie les deux substrats différents l'un à l'autre.

15. Enceinte (1) selon au moins l'une des revendications précédentes, dans laquelle les substrats (3, 4a, 4b, 4c, 4d, 4e, 4f, 5) comprennent une épaisseur inférieure à 3 mm, de préférence inférieure à 1500 µm, de préférence inférieure à 500 µm, de préférence inférieure à 120 µm et mieux encore inférieure à 80 µm, et/ou
dans laquelle la couche de couverture de base (3) et/ou la couche de couverture supérieure (5) est plus mince que la ou lesdites couches intermédiaires (4a, 4b, 4c, 4d, 4e, 4f), comprenant par exemple la moitié de la largeur des couches intermédiaires ou moins.

16. Enceinte (1) selon au moins l'une des revendications précédentes, dans laquelle au moins l'une des couches de substrat (3, 4a, 4b, 4c, 4d, 4e, 4f, 5), par exemple la couche de couverture de base (3), comprend des trous d'interconnexion pour établir un contact électrique entre la zone de fonction (12, 13) et l'environnement extérieur de l'enceinte, par exemple une plage de contact sur le côté inférieur de la couche de couverture de base.

17. Enceinte (1) selon au moins l'une des revendications précédentes, dans laquelle l'enceinte comprend une taille de 10 mm x 10 mm ou moins, de préférence 5 mm x 5 mm ou moins, de préférence encore 2 mm x 2 mm ou 1 mm x 1 mm ou moins, et/ou dans laquelle l'enceinte comprend une hauteur qui est plus grande que sa largeur.

18. Utilisation d'une enceinte (1) selon au moins l'une des revendications précédentes pour fabriquer un implant médical, un composé de lentille microscopique, une micropuce optique, un emballage pharmaceutique, une diode électroluminescente ou un ensemble optique pour un dispositif de réalité augmentée.

19. Procédé de fourniture d'une enceinte (1) selon l'une quelconque des revendications précédentes, dans lequel l'enceinte renferme une zone de fonction (12, 13) telle qu'une cavité (12), le procédé comprenant les étapes suivantes :
fournir un substrat de base (3) et aligner un substrat de couverture (5) au-dessus du substrat de base de telle manière qu'au moins une surface de contact (25) est placée entre le substrat de base et le substrat de couverture,
rendre étanche la zone de fonction par l'introduction d'une première ligne de soudure au laser (8) dans l'enceinte,
introduire une deuxième ligne de soudure au laser (8a, 8b, 8c, 8d, 8e, 8f) à la même position que la première ligne de soudure au laser ou en une position proche ou chevauchant la première ligne de soudure au laser, et réduire la contrainte dans la région de la première ligne de soudure au laser de l'enceinte grâce à l'introduction de ladite deuxième ligne de soudure au laser,
dans lequel au moins le substrat de couverture comprend un verre ou un matériau de type verre ou un matériau à base de silicium et dans lequel de préférence le substrat de base comprend aussi un verre ou un matériau de type verre ou un matériau à base de silicium.

20. Procédé de fourniture d'une enceinte (1) selon la revendication précédente,
dans lequel on utilise une source de faisceau laser (9) pour introduire les lignes de soudure au laser (8, 8a, 8b, 8c, 8d, 8e, 8f) dans l'enceinte ; et
dans lequel le faisceau laser est guidé autour de la zone de fonction (12, 13) pour réaliser la ligne de soudure au laser le long de la région de contact (25) entre le substrat de base (3) et le substrat de couverture (5).

21. Procédé selon la revendication précédente, dans lequel la source laser (9) est une source de laser à impulsions et dans lequel plusieurs impulsions laser sont introduites le long de la ligne de soudure au laser (8, 8a, 8b, 8c, 8d, 8e, 8f), de sorte qu'une ligne de soudure continue ou du type continu est composée à partir des différentes impulsions laser.

22. Enceinte étanche trempée (1) fabriquée au moyen du procédé de l'une quelconque des précédentes revendications de procédé.
